# EUROPÄISCHE PATENTSCHRIFT

(11) **EP 3 449 495 B1**
(45) Veröffentlichungstag und Bekanntmachung des Hinweises auf die Patenterteilung: **11.06.2025**
(21) Anmeldenummer: 17721579.5
(22) Anmeldetag: 26.04.2017
(51) Int. Cl.: H01G 4/232

(54) **VIELSCHICHTBAUELEMENT**
MULTI-LAYERED COMPONENT
COMPOSANT MULTICOUCHE

(30) Priorität: 26.04.2016 DE 202016102203 U
(43) Veröffentlichungstag der Anmeldung: 06.03.2019
(73) Patentinhaber: TDK Electronics AG, 81671 München (DE); Robert Bosch GmbH, 70442 Stuttgart (DE)
(72) Erfinder: GALLER, Martin, 8401 Kalsdorf (AT); PUCHLEITNER, Roman, 8083 St. Stefan (AT); RAJAPURKAR, Aditya, 8042 Graz (AT)
(74) Vertreter: Epping - Hermann - Fischer
(86) Internationale Anmeldenummer: PCT/EP2017/059863
(87) Internationale Veröffentlichungsnummer: WO 2017/186758

(56) Entgegenhaltungen:
- DE-A1- 102009 029 571
- DE-A1- 102010 055 621
- US-A1- 2013 241 360
- US-A1- 2016 056 366

## Beschreibung

Die vorliegende Erfindung betrifft ein Vielschichtbauelement. Insbesondere kann das Vielschichtbauelement als Drucksensor ausgebildet sein, der einen Druck beziehungsweise eine Druckschwankung mit Hilfe des piezoelektrischen Effektes misst oder anzeigt. Der auf den Drucksensor einwirkende Druck ruft ein elektrisches Signal hervor, beispielsweise einen elektrischen Ladungsfluss.

Ein derartiger Drucksensor kann beispielsweise in der Closed-Loop Regelung (geschlossener Regelkreis) der Einspritzmengen in Dieselinjektoren zum Einsatz kommen. Aus der DE 10 2013 200 242 A1 ist ein piezokeramischer Drucksensor bekannt.

Aus der US 2016/056366 A1 ist ein piezoelektrischer Aktor mit einer Außenelektrodengeometrie bekannt, mit der eine gewünschte Polung von Keramikschichten erhalten werden kann. Aus der DE 10 2009 029571 A1 ist ein piezoelektrischer Aktor mit einer Außenelektrodengeometrie bekannt, mit der inaktive Bereiche bei Bedarf zugeschaltet werden. Aus der DE 10 2010 055621 A1 ist ein Piezoaktor bekannt, bei dem auf einer Außenseite eine Außenelektrode und auf einer gegenüberliegenden Außenseite mehrere Außenelektroden angeordnet sind, um Aktorabschnitte zeitversetzt ansteuern zu können.

Aus der US 2013/241360 A1 ist ein piezoelektrisches Vielschichtbauelement bekannt, bei dem eine Außenelektrode eine Einkerbung zur Kenntlichmachung der Polarität aufweist.

Es ist eine Aufgabe der vorliegenden Erfindung ein Vielschichtbauelement mit verbesserten Eigenschaften anzugeben.

Diese Aufgabe wird durch ein Vielschichtbauelement gemäß dem vorliegenden Anspruch 1 gelöst.

Das Vielschichtbauelement weist einen Grundkörper mit einer Vielzahl von keramischen Schichten und Innenelektroden auf.

Zudem weist das Vielschichtbauelement genau zwei Außenelektroden zur Kontaktierung der Innenelektroden auf.

Das Vielschichtbauelement weist einen Grundkörper mit einer Vielzahl von keramischen Schichten und Innenelektroden auf und weist genau zwei Außenelektroden zur Kontaktierung der Innenelektroden auf, wobei sich die Außenelektroden zur Kenntlichmachung ihrer Polarität in ihren Abmessungen unterscheiden, wobei die Außenelektroden, abgesehen von optional vorhandenen abgerundeten Ecken, jeweils eine einheitliche Höhe in Richtung der Stapelrichtung der Schichten und jeweils eine einheitliche Breite in einer Richtung senkrecht dazu aufweisen, wobei die Breite der ersten Außenelektrode größer ist als die Breite der zweiten Außenelektrode.

Insbesondere kann das Vielschichtbauelement als Drucksensor ausgebildet sein. Der Drucksensor ist beispielsweise als NCS-Sensor (needle closing sensor) ausgebildet, der das Schließen einer Ventilnadel eines Brennstoffeinspritzventils überwacht.

Der Drucksensor ist beispielsweise derart ausgebildet, dass bei Einwirkung eines Drucks auf eine Oberseite und/oder eine Unterseite des Grundkörpers ein elektrisches Signal an den Außenelektroden abgreifbar ist. Die Oberseite und Unterseite sind dabei die Seiten, die den Grundkörper in Stapelrichtung der Schichten, nach oben und unten abschließen. Die Außenelektroden sind beispielsweise an Seitenflächen angeordnet, die nicht die Oberseite und nicht die Unterseite des Stapels bilden. Beispielsweise sind die Seitenflächen senkrecht zur Oberseite und Unterseite angeordnet.

Die Außenelektroden sind beispielsweise schichtförmig auf den Seitenflächen angeordnet. Insbesondere können die Außenelektroden als Sputterschichten ausgebildet sein. Die Außenelektroden können die Materialien Chrom, Nickel und Silber aufweisen. Beispielsweise weisen die Außenelektroden einen CrNiAg-Schichtaufbauf auf.

Beispielsweise weist das Vielschichtbauelement wenigstens eine erste Innenelektrode, die mit einer ersten Außenelektrode elektrisch verbunden ist, und eine zweite Innenelektrode, die mit einer zweiten Außenelektrode elektrisch verbunden ist, auf.

Die Innenelektroden sind beispielsweise in einem Abstand von 0,1 mm bis 0,8 mm, beispielsweise von 0,4 mm +/- 0,05 mm zueinander angeordnet. Der Abstand entspricht ungefähr der Dicke der keramischen Schichten. Weiterhin kann das Vielschichtbauelement an seiner Ober- und Unterseite keramische Deckpakete aufweisen. Die Deckpakete weisen beispielsweise eine Dicke von 0,3 mm bis 0,8 mm auf. Die Dicke kann insbesondere bei 0,4 mm (+ 0,1 mm /- 0,05 mm) liegen.

Das Vielschichtbauelement kann eine Isozone aufweisen, in dem sich benachbarte gegenpolige Innenelektroden in Stapelrichtung nicht überlappen. Die Isozone ist beispielsweise umlaufend ausgebildet. Beispielsweise weist die Isozone eine Breite von 0,1 bis 0,5 mm auf.

Bei der Herstellung des Vielschichtbauelements werden die keramischen Schichten durch Anlegen einer elektrischen Spannung zwischen den Außenelektroden polarisiert. Diese Polarisation legt den elektrischen Anschluss des Vielschichtbauelements im Betrieb fest. Insbesondere ist eine der Außenelektroden als Plus-Elektrode und eine der Außenelektroden als Minus-Elektrode ausgebildet.

In einer Ausführungsform unterscheiden sich die Außenelektroden zur Kenntlichmachung ihrer Polarität. Beispielsweise weisen die Außenelektroden unterschiedliche Abmessungen, insbesondere auf der jeweiligen Seitenfläche, auf. Insbesondere sind die Außenelektroden derart ausgebildet, dass ihre Aufsichten nicht durch Drehung ineinander überführbar sind.

Aufgrund der unterschiedlichen Ausbildung der Außenelektroden ist eine weitere Polaritätsmarkierung, beispielsweise eine Beschriftung, nicht erforderlich. Dies ermöglicht auf einfache Weise eine korrekte Montage des Vielschichtbauelements, insbesondere einen korrekten elektrischen Anschluss der Außenelektroden.

Die Außenelektroden weisen jeweils eine Höhe in Richtung der Stapelrichtung der Schichten und eine Breite in einer Richtung senkrecht dazu auf. Die Höhen- und Breitenrichtung verläuft beispielsweise parallel zur Seitenfläche, auf der die Außenelektroden angeordnet sind.

In einer Ausführungsform weisen die Außenelektroden dieselbe Höhe, jedoch unterschiedliche Breiten auf. Erfindungsgemäß ist die Breite der ersten Außenelektrode größer als die Breite der zweiten Außenelektrode.

In einem Vergleichsbeispiel, welches nicht unter den Gegenstand des Schutzbegehrens fällt, unterscheiden sich die Außenelektroden in ihrer Anordnung auf dem Grundkörper. Beispielsweise ist die erste Außenelektrode mittig auf einer Seitenfläche angeordnet, während die zweite Außenelektrode zu einer Kante hin verschoben angeordnet ist.

Das Vielschichtbauelement weist beispielsweise eine Höhe, eine Länge und eine Breite auf, wobei die Höhe die Abmessung des Vielschichtbauelements in Stapelrichtung der Schichten, die Länge die Abmessung von eine der Außenelektroden zur anderen der Außenelektroden und die Breite die Abmessung senkrecht zu Höhe und Länge darstellt.

In einer Ausführungsform ist die Breite größer als die Höhe. Beispielsweise gilt für die Abmessungen: Breite x Länge x Höhe = (5,0 +/- 0,15) x (2,6 +/- 0,15) x (2,4 +/- 0,03) mm³. Diese Abmessungen sind in besonderem Maße bei einer Anwendung als Drucksensor bei einem Einspritzventil geeignet. In einer Ausführungsform weist das Vielschichtbauelement eine ungerade Zahl von Innenelektroden auf. Beispielsweise ist die Anzahl der Innenelektroden gleich fünf. Je nach den Anforderungen an das Outputsignal können auch mehr oder weniger Innenelektroden vorliegen. Vorzugsweise weist das Bauelement mindestens drei Innenelektroden auf.

Die Innenelektroden sind beispielsweise symmetrisch bezüglich einer Drehung um 180° um eine Längenachse ausgebildet. Die Längenachse verläuft dabei in Längenrichtung des Vielschichtbauelements, d.h., von einer Außenelektrode zur gegenüber liegenden Außenelektrode. Insbesondere kann das gesamte Vielschichtbauelement symmetrisch bezüglich einer derartigen Drehung ausgebildet sein.

Die Innenelektroden sind beispielsweise unsymmetrisch bezüglich einer Drehung von 180° um eine Höhenachse ausgebildet. Die Höhenachse verläuft dabei in Höhenrichtung des Vielschichtbauelements, d.h., in Stapelrichtung.

In einer Ausführungsform weisen die keramischen Schichten ein Material auf Basis von Blei-Zirkonat-Titanat (PZT) auf. Das PZT-Material kann eine Dotierung, insbesondere eine Nd-Dotierung, aufweisen. Durch die Dotierung kann eine hohe Stabilität der elektrischen Eigenschaften gegenüber Druckbelastung erreicht werden. Die Keramik kann durch die Wahl des Ti/Zr-Verhältnisses und damit bezüglich der Lage der morphotropen Phasengrenze optimiert sein. Auf diese Weise kann sichergestellt werden, dass das Vielschichtbauelement in der Anwendung eine hohe Konstanz des Outputsignals über die Lebensdauer aufweist.

In einer Ausführungsform enthalten die Innenelektroden Silber und Palladium. Insbesondere kann Silber in einem Anteil von 75 Gew.-% und Palladium in einem Anteil von 25 Gew.-% vorliegen.

Weiterhin wird ein Verfahren zur Herstellung eines Vielschichtbauelements angegeben. Das Vielschichtbauelement kann wie oben beschrieben ausgebildet sein. Beispielsweise werden im Verfahren keramische Grünfolien bereitgestellt, mit Innenelektroden bedruckt, aufeinander gestapelt und gemeinsam gesintert. Anschließend werden Außenelektroden aufgebracht, beispielsweise aufgesputtert. Danach wird das Vielschichtbauelement, insbesondere die keramische Schichten, durch Anlegen einer elektrischen Spannung zwischen den Außenelektroden polarisiert.

Die Polarisation findet beispielsweise statisch ohne Vorspannung bei 1 kV/mm bis 3 kV/mm, insbesondere bei 2,5 kV/mm, statt. Die Polarisation kann bei einer Temperatur von 20 °C bis 200 °C, insbesondere von 150 °C, erfolgen. Diese Polarisationsbedingungen haben sich als besonders günstig für die Stabilität der Parameter des Bauteils erwiesen. Bei spezifischen Anforderungen in der Anwendung können die Parameter entsprechend abgeändert werden.

Weiterhin wird ein Verfahren zum Betrieb des Vielschichtbauelements angegeben. Das Vielschichtbauelement wird dabei als Drucksensor zur Überwachung eines Drucks in einem Brennstoffeinspritzventil eingesetzt.

In der vorliegenden Offenbarung sind mehrere Aspekte einer Erfindung beschrieben. Alle Eigenschaften, die in Bezug auf das Bauelement oder eines der Verfahren offenbart sind, sind auch entsprechend in Bezug auf die anderen Aspekte offenbart, auch wenn die jeweilige Eigenschaft nicht explizit im Kontext der anderen Aspekte erwähnt wird.

Im Folgenden werden die hier beschriebenen Gegenstände anhand von schematischen Ausführungsbeispielen näher erläutert.

Es zeigen:
- Figur 1: eine Ausführungsform eines Vielschichtbauelements in perspektivischer Ansicht,
- Figur 2: das Vielschichtbauelement aus Figur 1 in einer seitlichen Ansicht,
- Figur 3: das Vielschichtbauelement aus Figur 1 in einem Längsschnitt,
- Figur 4: das Vielschichtbauelement aus Figur 1 in einer weiteren seitlichen Ansicht,
- Figur 5: das Vielschichtbauelement aus Figur 1 in einem weiteren Längsschnitt,
- Figur 6: das Vielschichtbauelement aus Figur 1 in einer Aufsicht,
- Figur 7: Prozessschritte bei der Herstellung eines Pulvers für die piezokeramischen Schichten eines Vielschichtbauelements in einem Ablaufdiagramm,
- Figur 8: Prozessschritte bei der Herstellung von Grünfolien für die piezokeramischen Schichten eines Vielschichtbauelements in einem Ablaufdiagramm,
- Figur 9: Prozessschritte bei der Herstellung eines Vielschichtbauelements aus Grünfolien in einem Ablaufdiagramm,
- Figur 10: Kapazitätswerte mehrerer Muster eines Vielschichtbauelements vor und nach zyklischer Belastung,
- Figur 11: Werte für die piezokeramische Ladungskonstante mehrerer Muster eines Vielschichtbauelements vor und nach zyklischer Belastung.

Vorzugsweise verweisen in den folgenden Figuren gleiche Bezugszeichen auf funktionell oder strukturell entsprechende Teile der verschiedenen Ausführungsformen.

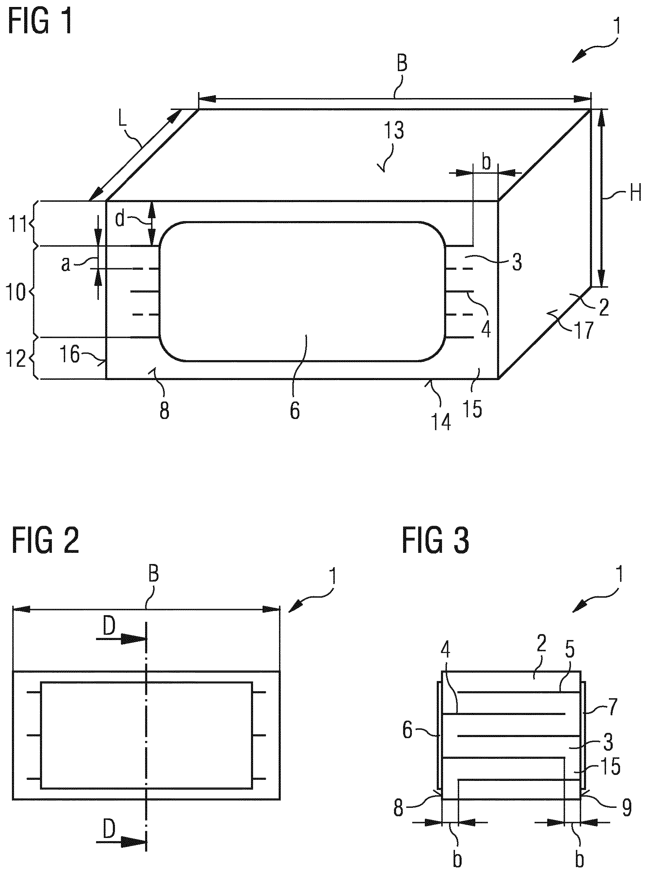

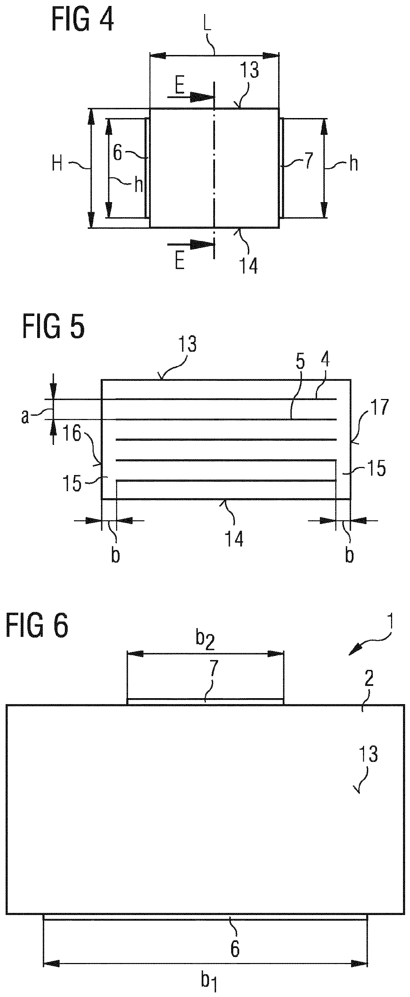

Figur 1 zeigt ein Vielschichtbauelement 1, das beispielsweise als Drucksensor ausgebildet ist. Ein derartiger Drucksensor kann beispielsweise in der Closed-Loop Regelung der Einspritzmengen in Dieselinjektoren zum Einsatz kommen. Dabei kann der Drucksensor als NCS-Sensor ausgebildet sein. Figur 2 zeigt das Vielschichtbauelement 1 in einer seitlichen Ansicht, Figur 3 in einer Schnittansicht entlang der in Figur 2 mit D-D gekennzeichneten Stelle, Figur 4 in einer weiteren seitlichen Ansicht und Figur 5 in einer Schnittansicht entlang der in Figur 4 mit E-E gekennzeichneten Stelle.

Das Vielschichtbauelement 1 weist einen Grundkörper 2 mit einer Vielzahl von keramischen Schichten 3 und Innenelektroden 4, 5 (siehe Figur 4) auf. Vorzugsweise sind alle keramischen Schichten 3 und Innenelektroden 4, 5 gemeinsam gesintert. Insbesondere handelt es sich bei den keramischen Schichten 3 um piezokeramische Schichten.

Das Vielschichtbauelement 1 weist zwei Außenelektroden 6, 7 (siehe Figur 4) auf, die an gegenüberliegenden Seitenflächen 8, 9 (siehe Figur 4) des Grundkörpers 2 angeordnet sind. Die Außenelektroden 6, 7 sind beispielsweise als eingebrannte metallische Schichten ausgebildet. Die Innenelektroden 4, 5 sind in Stapelrichtung abwechselnd mit einer der Außenelektroden 6, 7 elektrisch verbunden und von der anderen Außenelektrode 7, 6 elektrisch isoliert. Insbesondere reichen die Innenelektroden 4, 5 in Stapelrichtung abwechselnd bis zu einer der Seitenflächen 8, 9 und sind von der anderen Seitenfläche 9, 8 beabstandet.

Der Vielschichtbauelement 1 weist eine Breite B, eine Höhe H und eine Länge L auf. Die Höhe H ist dabei die Erstreckung des Vielschichtbauelements 1 in Stapelrichtung der keramischen Schichten 3 und Innenelektroden 4, 5. Die Länge L ist die Erstreckung des Vielschichtbauelements 1 von einer Außenelektrode 6 zur gegenüberliegenden Außenelektrode 7. Die Breite B ist die Erstreckung des Vielschichtbauelements 1 in einer Richtung senkrecht zur Höhe H und senkrecht zur Länge L. Beispielsweise ist die Breite B größer als die Höhe H und die Länge L. Insbesondere kann die Breite B doppelt so groß sein wie die Höhe H und die Länge L.

Beispielsweise liegt die Breite B im Bereich von 4,0 bis 6,0 mm. Insbesondere kann die Breite B bei 5,0 mm +/- 0,15 mm liegen. Beispielsweise liegt die Länge L im Bereich von 2,0 bis 3,0 mm. Insbesondere kann die Länge L bei 2,6 mm +/- 0,15 liegen. Beispielsweise liegt die Höhe H im Bereich von 2,0 und 3,0 mm. Insbesondere kann die Höhe H bei 2,4 mm +/-0,03 mm liegen. Das Vielschichtbauelement 1 weist beispielsweise die folgenden Abmessungen auf: Breite B x Länge L x Höhe H = 5,0 x 2,6 x 2,4 mm³.

Die Außenabmessungen des Vielschichtbauelements 1 resultieren insbesondere aus Vorgaben zum verfügbaren Bauraum, beispielsweise der möglichen Länge L und Breite B, und Anforderungen an das Outputsignal, das beispielsweise durch die Höhe H eingestellt werden kann.

Die keramischen Schichten 3 weisen beispielsweise ein mit Nd dotiertes PZT-Material auf, das bezüglich der Lage der morphotropen Phasengrenze optimiert ist. Beispielsweise liegt das Verhältnis Ti:Zr bei ungefähr 51:49.

Die Innenelektroden 4, 5 weisen beispielsweise eine Legierung aus Silber und Palladium auf. Insbesondere kann Silber in einem Anteil von 75 Gew.-% und Palladium in einem Anteil von 25 Gew.-% vorliegen. Die Innenelektroden 4, 5 werden in Schichtform auf die keramischen Grünfolien aufgebracht und zusammen mit den Grünfolien gesintert.

Beispielsweise weist das Vielschichtbauelement 1 eine ungerade Anzahl von Innenelektroden 4, 5 auf. In einer Ausführungsform weist das Vielschichtbauelement 1 insgesamt fünf Innenelektroden 4, 5 auf. Beispielsweise sind drei erste Innenelektroden 4 mit der ersten Außenelektrode 6 und zwei zweite Innenelektroden 5 mit der zweiten Außenelektrode 7 elektrisch verbunden. Entsprechend weist das Vielschichtbauelement 1 vier aktive keramische Schichten 3 auf, d.h., vier Keramikschichten 3, die zwischen gegenpoligen Innenelektroden 4, 5 angeordnet sind.

Die Innenelektroden 4, 5 sind beispielsweise in einem Abstand a im Bereich von 0,2 bis 0,6 mm angeordnet. In einer Ausführungsform gilt a = 0,4 mm. Die Schichtdicke der keramischen Schichten 3 ist etwas kleiner als der Abstand a der Innenelektroden 4, 5.

Das Vielschichtbauelement 1 weist einen aktiven Bereich 10 auf, der zwischen zwei Deckpaketen 11, 12 angeordnet ist. Im aktiven Bereich 10 sind Innenelektroden 4, 5 vorhanden, so dass sich bei Druckeinwirkung auf die keramischen Schichten 3 aufgrund des piezoelektrischen Effekts ein elektrisches Signal ergibt. In den Deckpaketen 11, 12 sind keine Innenelektroden 4, 5 vorhanden. Die Deckpakete 11, 12 weisen beispielsweise die gleiche Keramik auf wie die keramischen Schichten 3 im aktiven Bereich 10. Die Deckpakete 11, 12 bilden die Oberseite 13 und die Unterseite 14 des Bauelements.

Beispielsweise weisen die Deckpakete 11, 12 jeweils eine Dicke d im Bereich von 0,2 mm bis 0,6 mm auf. In einer Ausführungsform gilt d = 0,4 mm.

Die Oberseite 13 und die Unterseite 14 sind beispielsweise als die Aktivseiten eines als Drucksensors ausgebildeten Vielschichtbauelements 1 ausgebildet. Bei Druckeinwirkung auf die Oberseite 13 und/oder die Unterseite 14 verändert sich die Polarisation der piezokeramischen Schichten 2, so dass ein elektrisches Signal an den Außenelektroden 6, 7 erzeugt wird.

Das Vielschichtbauelement 1 weist eine umlaufende Isozone 15 auf. Als Isozone 15 wird der Bereich der keramischen Schichten 3 im aktiven Bereich 10 bezeichnet, der nicht zwischen überlappenden, gegenpoligen Innenelektroden 4, 5 angeordnet ist. Die Isozone 15 ist sowohl an den Seitenflächen 8, 9 ausgebildet, an denen die Außenelektroden 6, 7 angeordnet sind (Figur 1 und Figur 3), als auch an dazwischen liegenden Seitenflächen 16, 17 (Figur 5). Somit gibt es an keiner der Seitenflächen 8, 9, 16, 17 freiliegende gegenpolige Innenelektroden 4, 5. Somit wird eine Wechselwirkung, beispielsweise eine Ag-Migration, freiliegender gegenpoliger Innenelektroden 4, 5 mit der Umgebung verhindert.

Beispielsweise weist die Isozone 15 eine Breite b im Bereich von 0,1 mm bis 0,5 mm auf. In einer Ausführungsform gilt b = 0,3 mm. Die Isozone 15 kann an allen Seitenflächen 8, 9, 16, 17 eine einheitliche Breite b aufweisen.

Die Außenelektroden 6, 7 sind beispielsweise als gesputterte Schichten ausgebildet. Insbesondere können die Außenelektroden 6, 7 eine Sputterschicht aus CrNiAg aufweisen. Die Kombination der Materialien Chrom, Nickel und Silber in den Außenelektroden 6, 7 erweist sich als besonders günstig für sowohl die Haftfestigkeit der Außenelektroden 6, 7 am Grundkörper 2, insbesondere an der Keramik, als auch für die weitere elektrische Anbindung, z. B. durch Löten. Die Sputterschicht weist beispielsweise eine Dicke im Bereich von 0,8 µm auf.

Bei der Polarisierung des Bauelements 1 wird beispielsweise die erste Außenelektrode 6 mit einem Pluspol einer Spannungsquelle und die zweite Außenelektrode 7 mit einem Minuspol einer Spannungsquelle verbunden. Entsprechend kann die erste Außenelektrode 6 als P (Plus)-Elektrode und die zweite Außenelektrode 7 als M (Minus)-Elektrode bezeichnet werden.

Figur 6 zeigt das Vielschichtbauelement 1 in der Aufsicht. Insbesondere sind die Oberseite 13 und die Außenelektroden 6, 7 zu sehen.

Die Außenelektroden 6, 7 weisen unterschiedliche Abmessungen auf. Insbesondere weist die erste Außenelektrode 6 eine Breite b₁ auf, die größer ist als die Breite b₂ der zweiten Außenelektrode 7. Beispielsweise ist die erste Außenelektrode 6 mindestens 1,5 mal so breit wie die zweite Außenelektrode 7. Insbesondere kann die erste Außenelektrode doppelt so breit sein wie die zweite Außenelektrode 7. Beispielsweise weisen die erste und die zweite Außenelektrode 6, 7 gleiche Höhen h (siehe Figur 4) auf.

Beide Außenelektroden 6, 7 sind mittig auf der jeweiligen Seitenfläche 8, 9 angeordnet. In einem Vergleichsbeispiel, welches nicht unter den Gegenstand des Schutzbegehrens fällt, kann die Polaritätsmarkierung auch durch unterschiedliche Anordnungen der Außenelektroden 6, 7 auf den Seitenflächen 8, 9 und/oder durch eine Kombination aus Abmessung der Außenelektroden 6, 7 und Anordnung der Außenelektroden 6, 7 ausgebildet sein.

Insbesondere kann die erste Außenelektrode 6 eine Breite b₁ = 4 mm +/- 0,4 mm aufweisen. Die zweite Außenelektrode 7 kann eine Breite b₂ = 2 mm +/- 0,4 mm aufweisen. Beispielsweise können die erste und zweite Außenelektrode 6, 7 eine Höhe h = 2 mm +/- 0,15 mm aufweisen. Die zweite Außenelektrode 7 weist beispielsweise eine ungefähr quadratische Form auf, während die erste Außenelektrode 6 eine größere Breite b₁ als Höhe h aufweist. Die Außenelektroden 6, 7 können abgerundete Ecken aufweisen.

Durch die erkennbar unterschiedlichen Größen der Außenelektroden 6, 7 ist die Polarität der Außenelektroden 6, 7 erkennbar, ohne dass eine weitere Polaritätsmarkierung, wie z. B. eine Beschriftung, erforderlich ist. Der Anwender erhält beispielsweise lediglich die Information, dass die größere Außenelektrode 6 als P-Elektrode ausgebildet ist.

Das Vielschichtbauelement 1 ist insbesondere derart aufgebaut, dass die Erkennung der Polarität der Außenelektroden 6, 7 eine korrekte Montage ermöglicht. Die Innenelektroden 4, 5 sind symmetrisch bezüglich einer Drehung von 180° um eine Achse angeordnet, die in Längsrichtung des Vielschichtbauelements 1 auf halber Höhe und halber Breite des Vielschichtbauelements 1 verläuft. Somit kann das Vielschichtbauelement 1 in der in Figur 1 abgebildeten Orientierung oder in einer einer um 180° gedrehten Orientierung um die Achse montiert werden, ohne dass sich die Eigenschaften ändern.

Die Innenelektroden 4, 5 sind unsymmetrisch bezüglich einer Drehung um 180° um eine Achse angeordnet, die in Höhenrichtung des Vielschichtbauelements 1 auf halber Breite und halber Länge des Vielschichtbauelements 1 verläuft. Die korrekte Montage bezüglich dieser Achse wird durch die unterschiedlichen Abmessungen der Außenelektroden 6, 7 kenntlich gemacht.

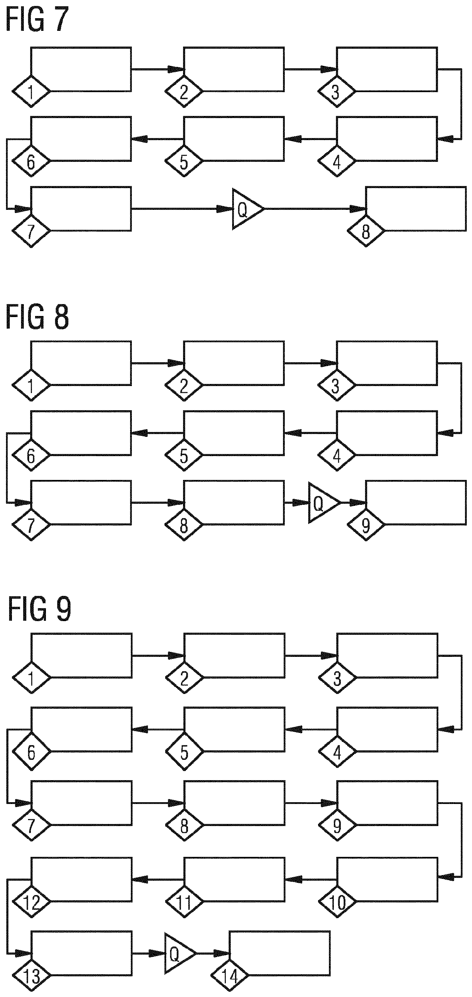

Die Figuren 7 bis 9 zeigen Prozessschritte bei der Herstellung eines Vielschichtbauelements, insbesondere des in den vorhergehenden Figuren 1 bis 6 gezeigten Vielschichtbauelements.

In Figur 7 sind Prozessschritte bei der Herstellung eines Pulvers für die keramischen Schichten 3 dargestellt.

Dabei wird ein Grundmaterial, insbesondere ein Material basierend auf Blei-Zirkonat-Titanat (PZT) bereitgestellt (Schritt 1, Fachausdruck "Delivery of raw material"). Das Grundmaterial wird gewogen (Schritt 2, Fachausdruck "Weighing"), dispergiert und gemahlen (Schritt 3, Fachausdruck "Dispersing / Milling"). Anschließend wird Wasser entfernt und das Material getrocknet (Schritt 4, Fachausdruck "Water removal / Drying). Das Material wird kalziniert (Schritt 5, Fachausdruck "Calcination") und gemahlen (Schritt 6, Fachausdruck "Milling"). Es folgt ein weiterer Trocknungsschritt (Schritt 7, Fachausdruck "Water removal / Drying").

Anschließend wird geprüft, ob das Material spezifische Qualitätsanforderungen erfüllt (Schritt Q, Fachausdruck "Q (Quality)-Gate"). Diese Qualitätsanforderungen sind beispielsweise die Korngröße und Zusammensetzung des Materials. Bei Erfüllung der Qualitätsanforderungen wird das Material freigegeben (Schritt 8, Fachausdruck "Delivery Powder").

In Figur 8 sind Prozessschritte bei der Herstellung von Folien für die keramischen Schichten 3 dargestellt.

Es werden ein keramisches Pulver, beispielsweise das mit dem in Figur 7 gezeigten Verfahren hergestellte Pulver, ein Bindemittel und Lösungsmittel bereitgestellt (Schritt 1, Fachausdruck "Binder / Solvents / Delivery of ceramic powder"). Anschließend werden die Komponenten gewogen (Schritt 2, Fachausdruck "Weighing of components"), vorgemischt (Schritt 3 Fachausdruck "Premixing"), dispergiert und gemahlen (Schritt 4, Fachausdruck "Dispersing / Milling") und gefiltert (Schritt 5, Fachausdruck "Filtration"). Danach erfolgt eine Entgasung und eine Viskositätsanpassung (Schritt 6, Fachausdruck "Degassing / Viscosity adjusting") und eine weitere Filterung (Schritt 7, Fachausdruck "Filtration"). Anschließend wird das Material in ein oder mehrere Folien gegossen (Schritt 8, Fachausdruck "Tape casting"). Die Schritte 7 und 8 erfolgen beispielsweise in einem Reinraum.

Anschließend wird geprüft, ob die Folie spezifische Qualitätsanforderungen erfüllt (Schritt Q, Fachausdruck "Q-Gate"). Diese Qualitätsanforderungen sind beispielsweise die Foliendicke und der E-Modulus. Bei Erfüllung der Qualitätsanforderungen wird die Folie freigegeben (Schritt 9, Fachausdruck "Delivery Tape").

In Figur 9 sind Prozessschritte bei der Herstellung des Vielschichtbauelements aus einer Folie dargestellt.

Es wird eine Folie, beispielsweise die mit dem in Figur 8 gezeigten Verfahren hergestellte Folie, bereitgestellt (Schritt 1, Fachausdruck "Delivery of ceramic tape"). Die Folie wird zu Blättern zurechtgeschnitten (Schritt 2, Fachausdruck "Cutting sheets"). Anschließend wird zur Herstellung der Innenelektroden 4, 5 eine AgPd-Paste auf die Folien gedruckt und getrocknet (Schritt 3, Fachausdruck "AgPd paste / Screen printing / drying"). Die Blätter werden aufeinander gestapelt und verpresst (Schritt 4, Fachausdruck "Stacking / Pressing"). Die Schritte 1 bis 4 werden beispielsweise im Reinraum durchgeführt.

Der Schichtstapel wird zurechtgeschnitten (Schritt 5, Fachausdruck "Cutting"), die Außenkanten werden durch Scheuern verrundet (Schritt 6, Fachausdruck "Tumbling"), entbindert (Schritt 7, Fachausdruck "Debindering") und gesintert (Schritt 8, Fachausdruck "Sintering").

Danach werden die Außenseiten des Sinterkörpers geläppt (Schritt 9, Fachausdruck "Lapping"). Insbesondere werden diejenigen Außenseiten 8, 9 geläppt, auf die später die Außenelektroden 6, 7 aufgebracht werden (Figur 3). Zum Aufbringen der Außenelektroden 6, 7 wird ein Sputtermaterial bereitgestellt und auf die Seitenflächen 8, 9 aufgesputtert (Schritt 10, Fachausdruck "Sputtering targets / Sputtering").

Anschließend wird das Vielschichtbauelement 1 polarisiert (Schritt 11, Fachausdruck "Polarization"). Die Polarisation erfolgt beispielsweise statisch ohne Vorspannung bei 2,5 kV/mm. Es kann dabei eine Temperatur von 150°C vorliegen.

Es erfolgt eine Endmessung (Schritt 12 Fachausdruck "Final measurement"), eine optische Kontrolle und eine Konfektionierung der Vielschichtbauelemente (Schritt 13, Fachausdruck "Optical control / packaging").

Anschließend wird geprüft, ob das Vielschichtbauelement 1 spezifische Qualitätsanforderungen erfüllt (Schritt Q, Fachausdruck "Q-Gate"). Diese Qualitätsanforderungen sind beispielsweise der d33-Wert und die Geometrie des Bauelements. Bei Erfüllung der Qualitätsanforderungen wird das Vielschichtbauelement freigegeben (Schritt 14, Fachausdruck "Delivery").

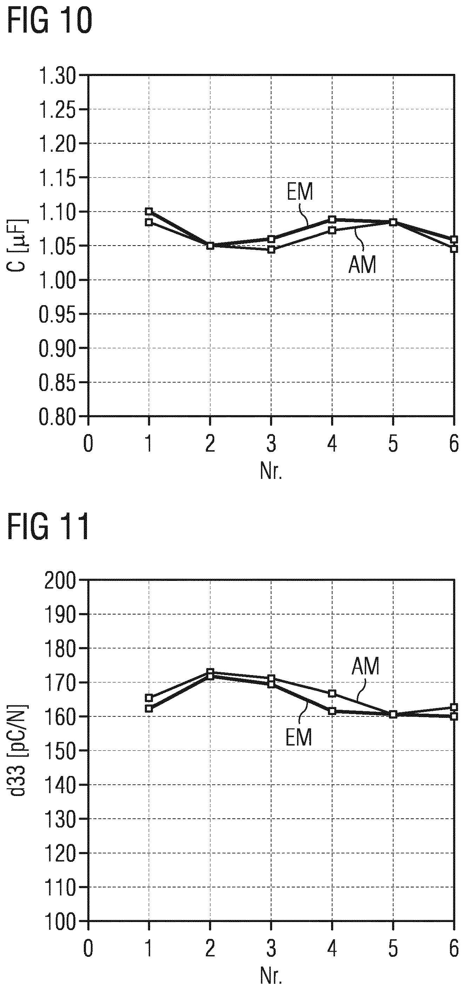

Figur 10 zeigt Messwerte der Kapazität C in µF für mehrere Muster Nr. 1 bis 6 eines als Drucksensor ausgebildeten Vielschichtbauelements 1 vor und nach zyklischer Belastung. Das Vielschichtbauelement 1 ist beispielsweise wie in den Figuren 1 bis 6 ausgebildet und mit einem Verfahren gemäß den Figuren 7 bis 9 hergestellt.

Es wurde jeweils eine Anfangsmessung AM und eine Endmessung EM durchgeführt, wobei das Vielschichtbauelement 1 zwischen den Messungen einer zyklischen Belastung (1e8 Zyklen) mit 150 N bei 200 N Vorspannung ausgesetzt wurde. Die Kapazität lag bei den Mustern Nr. 1 bis 6 im Bereich von 1,05 µF bis 1,10 µF, wobei sich bei 1e8 Zyklen eine Abweichung zwischen Anfangsmessung und Endmessung von kleiner 0,2 µF ergab.

Figur 11 zeigt Messwerte der piezoelektrischen Ladungskonstanten d₃₃ für mehrere Muster Nr. 1 bis 6 des Vielschichtbauelements 1 vor und nach zyklischer Belastung mit 150 N bei 200 Vorspannung.

Der d₃₃-Wert lag zwischen 160 pC/N und 175 pC/N mit einer Abweichung zwischen Anfangsmessung AM und Endmessung EM von kleiner 8 pC/N.

Insgesamt hat sich somit bei Messungen des Vielschichtbauelements 1 eine hohe Stabilität des Outputsignals bestätigt.

Die Beschreibung der hier angegebenen Gegenstände ist nicht auf die einzelnen speziellen Ausführungsformen beschränkt.

Vielmehr können die Merkmale der einzelnen Ausführungsformen - soweit technisch sinnvoll - miteinander kombiniert werden.

### Bezugszeichenliste

- 1: Vielschichtbauelement
- 2: Grundkörper
- 3: keramische Schicht
- 4: erste Innenelektrode
- 5: zweite Innenelektrode
- 6: erste Außenelektrode
- 7: zweite Außenelektrode
- 8: erste Seitenfläche
- 9: zweite Seitenfläche
- 10: aktiver Bereich
- 11: oberes Deckpaket
- 12: unteres Deckpaket
- 13: Oberseite
- 14: Unterseite
- 15: Isozone
- 16: Seitenfläche
- 17: Seitenfläche

- a: Abstand der Innenelektroden
- d: Dicke eines Deckpakets
- b: Breite der Isozone
- b₁: Breite der ersten Außenelektrode
- b₂: Breite der zweiten Außenelektrode
- h: Höhe der Außenelektroden

- B: Breite des Vielschichtbauelements
- H: Höhe des Vielschichtbauelements
- L: Länge des Vielschichtbauelements

- AM: Anfangsmessung
- EM: Endmessung

## Patentansprüche

1. Vielschichtbauelement,
aufweisend einen Grundkörper (2) mit einer Vielzahl von keramischen Schichten (3) und Innenelektroden (4, 5) und aufweisend genau zwei Außenelektroden (6, 7) zur Kontaktierung der Innenelektroden (4, 5), wobei sich die Außenelektroden (6, 7) zur Kenntlichmachung ihrer Polarität in ihren Abmessungen unterscheiden, **gekennzeichnet dadurch, dass** die Außenelektroden (6, 7), abgesehen von optional vorhandenen abgerundeten Ecken, jeweils eine einheitliche Höhe (h) in Richtung der Stapelrichtung der Schichten (3) und jeweils eine einheitliche Breite (b₁, b₂) in einer Richtung senkrecht dazu aufweisen, wobei die Breite (b₁) der ersten Außenelektrode (6) größer ist als die Breite (b₂) der zweiten Außenelektrode (7).

2. Vielschichtbauelement nach Anspruch 1,
das als Drucksensor ausgebildet ist.

3. Vielschichtbauelement nach einem der vorhergehenden Ansprüche, das eine ungerade Anzahl von Innenelektroden (4, 5) aufweist.

4. Vielschichtbauelement nach einem der vorhergehenden Ansprüche, bei dem die Anzahl der Innenelektroden (4, 5) gleich fünf ist.

5. Vielschichtbauelement nach einem der vorhergehenden Ansprüche, aufweisend eine Höhe (H), eine Länge (L) und eine Breite (B), wobei die Höhe (H) die Abmessung des Vielschichtbauelements (1) in Stapelrichtung der Schichten (3), die Länge (L) die Abmessung von einer der Außenelektroden (6) zur anderen der Außenelektroden (7) und die Breite (B) die Abmessung senkrecht zu Höhe (H) und Länge (L) kennzeichnet, wobei die Breite (B) größer ist als die Höhe (H).

6. Vielschichtbauelement nach Anspruch 5 mit den Abmessungen Breite (B) x Länge (L) x Höhe (H) = (5,0 +/- 0,15) x (2,6 +/-0,15) x (2,4 +/- 0,03) mm³.

7. Vielschichtbauelement nach einem der vorhergehenden Ansprüche, bei dem die keramischen Schichten (3) eine PZT-Keramik mit Nd-Dotierung enthalten.

8. Vielschichtbauelement nach einem der vorhergehenden Ansprüche, bei dem die Innenelektroden (4, 5) Silber-Palladium enthalten.

9. Vielschichtbauelement nach einem der vorhergehenden Ansprüche, bei dem die Innenelektroden (4, 5) in einem Abstand (a) von 0,4 +/- 0,05 mm zueinander angeordnet sind.

10. Vielschichtbauelement nach einem der vorhergehenden Ansprüche, bei dem eine Isozone (15) eine Breite (b) von 0,1 bis 0,5 mm aufweist.

11. Vielschichtbauelement nach einem der vorhergehenden Ansprüche, bei dem die Außenelektroden (6, 7) CrNiAg aufweisen.

12. Vielschichtbauelement nach einem der vorhergehenden Ansprüche, das zur Überwachung eines Drucks in einem Brennstoffeinspritzventil ausgebildet ist.

13. Vielschichtbauelement nach einem der vorhergehenden Ansprüche, bei dem die Breite (b₁) der ersten Außenelektrode (6) mindestens 1,5 mal so groß ist wie die Breite (b₂) der zweiten Außenelektrode (7).

## Claims

1. Multi-layered component,
having a main body (2) with a multiplicity of ceramic layers (3) and internal electrodes (4, 5) and having exactly two external electrodes (6, 7) for making contact with the internal electrodes (4, 5), wherein the external electrodes (6, 7) differ in their dimensions in order to indicate their polarity, **characterized in that**
the external electrodes (6, 7), apart from optionally present rounded corners, each have a uniform height (h) in the direction of the stacking direction of the layers (3) and each have a uniform width (b₁, b₂) in a direction perpendicular thereto, wherein the width (b₁) of the first external electrode (6) is greater than the width (b₂) of the second external electrode (7).

2. Multi-layered component according to Claim 1, which is in the form of a pressure sensor.

3. Multi-layered component according to either of the preceding claims, which has an odd number of internal electrodes (4, 5).

4. Multi-layered component according to one of the preceding claims, in which the number of internal electrodes (4, 5) is equal to five.

5. Multi-layered component according to one of the preceding claims, having a height (H), a length (L) and a width (B), wherein the height (H) denotes the dimension of the multi-layered component (1) in the stacking direction of the layers (3), the length (L) denotes the dimension from one of the external electrodes (6) to the other of the external electrodes (7) and the width (B) denotes the dimension perpendicular to height (H) and length (L), wherein the width (B) is greater than the height (H).

6. Multi-layered component according to Claim 5, with the dimensions width (B) x length (L) x height (H) = (5.0 +/- 0.15) x (2.6 +/- 0.15) x (2.4 +/- 0.03) mm³.

7. Multi-layered component according to one of the preceding claims, in which the ceramic layers (3) contain a PZT ceramic with Nd doping.

8. Multi-layered component according to one of the preceding claims, in which the internal electrodes (4, 5) contain silver-palladium.

9. Multi-layered component according to one of the preceding claims, in which the internal electrodes (4, 5) are arranged at a distance (a) of 0.4 +/- 0.05 mm from one another.

10. Multi-layered component according to one of the preceding claims, in which an isozone (15) has a width (b) of 0.1 to 0.5 mm.

11. Multi-layered component according to one of the preceding claims, in which the external electrodes (6, 7) comprise CrNiAg.

12. Multi-layered component according to one of the preceding claims, which is designed to monitor a pressure in a fuel injection valve.

13. Multi-layered component according to one of the preceding claims, in which the width (b₁) of the first external electrode (6) is at least 1.5 times as large as the width (b₂) of the second external electrode (7).

## Revendications

1. Composant multicouche,
comportant un corps de base (2) avec une pluralité de couches céramiques (3) et d'électrodes intérieures (4, 5) et comportant précisément deux électrodes extérieures (6, 7) destinés à être mises en contact avec les électrodes intérieures (4, 5), les électrodes extérieures (6, 7) se distinguant dans leurs dimensions pour indiquer leur polarité, **caractérisé en ce que**
les électrodes extérieures (6, 7) présentent, abstraction faite de coins arrondis présents en option, chacune une hauteur uniforme (h) en direction de la direction d'empilement des couches (3) et chacune une largeur uniforme (l₁, l₂) dans une direction perpendiculaire à celle-ci, la largeur (l₁) de la première électrode extérieure (6) étant plus grande que la largeur (l₂) de la seconde électrode extérieure (7).

2. Composant multicouche selon la revendication 1,
qui est réalisé en tant que capteur de pression.

3. Composant multicouche selon l'une des revendications précédentes, qui comporte un nombre impair d'électrodes intérieures (4, 5).

4. Composant multicouche selon l'une des revendications précédentes, où le nombre des électrodes intérieures (4, 5) est égal à cinq.

5. Composant multicouche selon l'une des revendications précédentes, présentant une hauteur (H), une longueur (L) et une largeur (l), la hauteur (H) caractérisant la dimension du composant multicouche (1) dans la direction d'empilement des couches (3), la longueur (L) caractérisant la dimension d'une des électrodes extérieures (6) par rapport à l'autre des électrodes extérieures (7) et la largeur (l) caractérisant la dimension perpendiculaire à la hauteur (H) et la longueur (L), la largeur (l) étant plus grande que la hauteur (H).

6. Composant multicouche selon la revendication 5 avec les dimensions largeur (l) x longueur (L) x hauteur (H) = (5,0 +/- 0,15) x (2,6 +/- 0,15) x (2,4 +/- 0,03) mm³.

7. Composant multicouche selon l'une des revendications précédentes, où les couches céramiques (3) contiennent une céramique PZT avec dopage Nd.

8. Composant multicouche selon l'une des revendications précédentes, où les électrodes intérieures (4, 5) contiennent de l'argent-palladium.

9. Composant multicouche selon l'une des revendications précédentes, où les électrodes intérieures (4, 5) sont disposées à une distance (a) de 0,4 +/- 0,05 mm les unes par rapport aux autres.

10. Composant multicouche selon l'une des revendications précédentes, où une isozone (15) présente une largeur (b) de 0,1 bis 0,5 mm.

11. Composant multicouche selon l'une des revendications précédentes, où les électrodes extérieures (6, 7) comportent du CrNiAg.

12. Composant multicouche selon l'une des revendications précédentes, qui est réalisé pour surveiller une pression dans une soupape d'injection de carburant.

13. Composant multicouche selon l'une des revendications précédentes, où la largeur (l₁) de la première électrode extérieure (6) est au moins 1,5 fois plus grande que la largeur (l₂) de la seconde électrode extérieure (7).
